# EUROPÄISCHE PATENTSCHRIFT

(11) **EP 3 161 856 B1**
(45) Veröffentlichungstag und Bekanntmachung des Hinweises auf die Patenterteilung: **12.10.2022**
(21) Anmeldenummer: 15737977.7
(22) Anmeldetag: 26.06.2015
(51) Int. Cl.: H01L 21/20, B81C 3/00

(54) **VERFAHREN ZUR HERSTELLUNG EINES OPTISCHEN ELEMENTES MIT MIKROOPTISCHEN STRUKTUREN, ANORDNUNG UND MEMBRANEINHEIT**
METHOD FOR PRODUCING AN OPTICAL ELEMENT COMPRISING MICRO-OPTICAL STRUCTURES, ARRANGEMENT AND MEMBRANE UNIT
PROCÉDÉ DE FABRICATION D'UN ÉLÉMENT OPTIQUE COMPORTANT DES STRUCTURES MICRO-OPTIQUES, AGENCEMENT ET UNITÉ DE MEMBRANE

(30) Priorität: 26.06.2014 DE 102014009285
(43) Veröffentlichungstag der Anmeldung: 03.05.2017
(73) Patentinhaber: JENOPTIK Optical Systems GmbH, 07745 Jena (DE)
(72) Erfinder: ZIENER, Christian, 07749 Jena (DE)
(74) Vertreter: Waldauf, Alexander
(86) Internationale Anmeldenummer: PCT/EP2015/001297
(87) Internationale Veröffentlichungsnummer: WO 2015/197195

(56) Entgegenhaltungen:
- WO-A2-2006/073829
- US-A1- 2004 063 322
- US-A1- 2009 253 245
- US-B2- 8 754 505

## Beschreibung

Die Erfindung betrifft ein Verfahren zur Herstellung eines optischen Elementes mit mikrooptischen Strukturen, ein derartiges optisches Element, und eine Anordnung zu dessen Herstellung.

In optischen Systemen kommen oft sogenannte diffraktive Elemente oder Anordnungen zum Einsatz. Dabei werden Interferenzeffekte, welche auf den Welleneigenschaften des Lichts beruhen, benutzt, um an einer bestimmten Stelle im optischen System eine gewünschte Feldverteilung zu realisieren. Es kommen sowohl Amplituden- wie auch Phasen-beeinflussende diffraktive Strukturen oder Kombinationen davon zum Einsatz. Die Anwendungen dieser Art der diffraktiven "Strahlformung" sind heute sehr zahlreich, sie reichen von der Erzeugung mehrerer, möglichst im hohen Maße gleicher, Strahlen (sogenannte Strahlteiler) über die Erzeugung von speziellen Strahlprofilen (sogenannte Strahlformer) für Laser bis hin zur Erzeugung von sogenannten Off-Axis-Beleuchtungsmodi in der Halbleiterlithographie, welche zur Erhöhung des optischen Auflösungsvermögens des optischen Systems dieser Belichtungsgeräte eingesetzt werden.

Im EUV-Spektralbereich (EUV = extrem-ultraviolett), das heißt im Wellenlängenbereich von 5 nm bis 30 nm gibt es keine echt transparenten Materialien, d. h. entweder werden diffraktive Strukturen auf einer dünnen (und dadurch nur gering absorbierenden) Membran durch das Aufbringen von strukturierten Absorberschichten hergestellt oder die Absorberschicht wird als Hartmaske dafür benutzt, die Membran komplett durchzuätzen.

Diese (Träger-)Membranen werden oft aus Si_{X}N_{Y} hergestellt, welche als dünner Film auf einem Silizium-(Si-)Wafer aufgebracht wird, wonach anschließend in einem trocken- oder nasschemischen Verfahren das Silizium des Wafers selbst entfernt wird, sodass nur die dünne (z. B. 100 nm dicke) Membran stehen bleibt, welche an ihrem Rand vom Wafer gehalten wird. Durch eine geeignete Prozess-Führung bei der Beschichtung des Wafers kann eine Ebenheit der frei stehenden Membran gewährleistet werden, welche der Ebenheit des sie tragenden Wafers entspricht.

Diese Membranwafer müssen, um sie in optische Systeme integrieren zu können, auf Halter aufgebracht werden, was z. B. durch Kleber erfolgen kann, welche bei höheren Temperaturen aushärten. Beim adhäsiven Bonden wiederum erfolgt die Verbindungsbildung ohne Klebstoff als Zwischensubstrat. Als Trägermaterialien kommen dabei vor allem Materialien mit geringem CTE in Betracht, beispielsweise Keramik, SiC oder SiSiC.

Bei einer Ungleichheit der thermischen Ausdehnungskoeffizienten von Wafer und Träger kommt es dabei durch "Bi-Metall"-ähnliche Effekte zu einer dauernden Verbiegung des Wafers und damit einer Unebenheit der mikrooptischen Strukturen. Soweit bekannt existiert kein Verfahren, die Wafer nach dem Aufkleben/Bonden zu "glätten" bzw. durch eine geeignete Anordnung die Ebenheit der aufgeklebten Wafer (und damit der Membranen) zu erhöhen.

Um den Stress zwischen miteinander verklebten Materialien, welche einen unterschiedlichen thermischen Ausdehnungskoeffizienten aufweisen, zu verringern bzw. um eine Verbiegung des aufgeklebten Wafers zu verhindern oder zu verringern werden in der Literatur verschiedene Verfahren beschrieben. In US7,067,393 B2 wird z. B. eine Anordnung beschrieben, bei der in das Substrat Gräben eingebracht werden, welche anschließend mit einem anderen Material wieder aufgefüllt werden. Für die Verklebung von Membranwafern mit hoher Ebenheit und Stabilität auf mechanischen Haltern (Substraten) hat diese Anordnung den Nachteil, dass die Festigkeit und damit Langzeitstabilität des Halters/Substrates geschwächt wird. Außerdem ist es bei der Montage von Membranwafern mit mikrooptischen Strukturen oft notwendig, diese nur punktuell zu verkleben, wodurch die Wirksamkeit einer solchen Schicht von vornherein eingeschränkt wird. Eine ähnliche Anordnung bzw. Methode wird in US 8,754,505 B2 beschrieben. Auch hier kommen die gleichen Nachteile bzgl. der Halterung/Montage von Membranwafern zum Tragen.

Ferner offenbart die US 2009/0253245 A1 eine Waferbonding-Methode zwischen einem ersten Wafer und einer Mehrzahl an zweiten Wafern. Die US 2004/0063322 A1 offenbart Techniken, um eine Membran von einem ersten Wafer zu einem zweiten Wafer zu transferieren. Die WO 2006/073829 A2 offenbart ein Bondingsystem mit Spannungskontrolle.

### Nachteile des Standes der Technik:

Durch die Aushärtung des Klebers bei hohen Temperaturen kommt es zu einer unerwünschten Verbiegung des Wafers und damit zu einer Verbiegung der Membranen bzw. einer Verlagerungen der Membranen zueinander.

Aufgabe der Erfindung ist es, basierend auf den Nachteilen des Standes der Technik, ein Verfahren zur Herstellung eines optischen Elementes, welches eine oder mehrere mikrooptische Strukturen auf einer dünnen Membran aufweist, bereitzustellen, wobei im Falle von einer Membran diese selbst eine sehr geringe Unebenheit aufweist und im Falle von mehreren Membranen diese zusätzlich zueinander geringe Höhenunterschiede / Unebenheiten aufweisen. Die unerwünschte Verbiegung des Wafers und die damit verbundene Verbiegung der Membranen bzw. einer Verlagerungen der Membranen zueinander soll verhindert bzw. zumindest verringert werden.

Diese Aufgabe wird durch die Merkmale der unabhängigen Ansprüche gelöst. Vorteilhafte Ausgestaltungen sind Gegenstand der abhängigen Ansprüche.

Der hier vorgestellte Ansatz schafft ein Verfahren zur Herstellung eines optischen Elementes mit mikrooptischen Strukturen, dadurch gekennzeichnet, dass das Verfahren einen Schritt des Verbindens aufweist, in dem ein Membranwafer als Trägerbasis der mikrooptischen Strukturen über ein Zwischensubstrat, insbesondere mit einer Dicke von typischerweise 100µm bis zu 10 mm, mit einem Träger verbunden wird, wobei die thermischen Ausdehnungskoeffizienten des Membranwafers, des Zwischensubstrats und des Trägers so bemessen sind, dass ein Ausdehnungskoeffizient des Trägers größer als ein Ausdehnungskoeffizient des Zwischensubstrats ist und ein Ausdehnungskoeffizient des Zwischensubstrats größer oder gleich einem Ausdehnungskoeffizienten des Membranwafers ist.

Unter einer Membran kann eine flächig ausgedehnte Struktur mit einer Dicke von 10 nm bis wenigen Mikrometern verstanden werden, die zumindest teilweise für ultraviolettes, insbesondere extrem-ultraviolettes Licht transparent ist. Unter einer mikrooptischen Struktur kann eine Struktur verstanden werden, bei der die Abmessungen der optisch wirksamen Elemente beispielsweise im Bereich der Wellenlänge des ultravioletten oder extrem-ultravioletten Lichts liegen. Ein Ausdehnungskoeffizient ist eine physikalische Eigenschaft eines Materials, der die Ausdehnung oder Kontraktion eines vorbestimmten Materials bei einer Veränderung der Temperatur dieses Materials bezeichnet.

Die Erfindung basiert auf der Erkenntnis, dass durch die Auswahl von Materialien mit unterschiedlichen Ausdehnungskoeffizienten für den Träger, das Zwischensubstrat und den Membranwafer bei der Herstellung von optischen Elementen, welche Membranen enthalten, sehr ebene bzw. planare Membranen hergestellt werden können. Dies liegt darin begründet, dass zum Verbinden des Trägers, das Zwischensubstrat und des Membranwafers meist Material (Kleber) verwendet wird, welches zum Aushärten eine Erhöhung der Umgebungstemperatur benötigt, wodurch sich der Träger, die Zwischensubstrat und der Membranwafer unterschiedlich stark bzw. weit ausdehnen. Nimmt nun die Temperatur wieder ab, ziehen sich die entsprechenden Teile wieder unterschiedlich stark zusammen, sodass der Träger, der den größten Ausdehnungskoeffizienten aufweist, den über die Zwischensubstrat darauf geklebten Membranwafer unter Spannung setzt, sodass der Membranwafer sehr eben oder planar gehalten wird.

Der hier vorgestellte Ansatz bietet den Vorteil, unter Verwendung von technisch sehr einfachen Mitteln durch die Auswahl von Materialien mit günstigen Ausdehnungskoeffizienten für den Membranwafer, das Zwischensubstrat oder den Träger sehr ebene Membrane herstellen zu können.

Besonders günstig ist eine Ausführungsform des hier vorgestellten Ansatzes, bei dem im Schritt des Verbindens der Membranwafer, das Zwischensubstrat und der Träger mit einem Klebermaterial verbunden werden, welcher bei einer Temperatur aushärtet, welche höher als die Raumtemperatur ist, insbesondere der bei einer Temperatur von zumindest 50 °C aushärtet. Eine solche Ausführungsform des hier vorgestellten Ansatzes bietet den Vorteil, dass sich der Membranwafer, das Zwischensubstrat und der Träger ausreichend stark ausdehnen, um bei einem nachfolgenden Auskühlen nach Aushärten des Klebematerials eine ausreichend große Zugkraft auf den Membranwafer bzw. die Membran hinreichend eben oder planar auszugestalten.

Denkbar ist ferner eine Ausführungsform des hier vorgeschlagenen Ansatzes, bei dem im Schritt des Verbindens ein Zwischensubstrat und ein Membranwafer verbunden werden, wobei der Ausdehnungskoeffizient des Zwischensubstrats gleich einem Ausdehnungskoeffizienten des Membranwafers ist.

Günstig ist ferner eine Ausführungsform des hier vorgeschlagenen Ansatzes, bei dem im Schritt des Verbindens eine Oberfläche des Membranwafers erzeugt wird, die planar ist, insbesondere die eine Durchbiegung von weniger als 1 µm aufweist. Eine solche Ausführungsform des hier vorgeschlagenen Ansatzes bietet den Vorteil einer möglichst geringen optischen Verzerrung der mikrooptischen Struktur bei einem Durchleuchten der Membran mit ultraviolettem bzw. extrem-ultraviolettem Licht.

Technisch besonders einfach ist eine Ausführungsform des hier vorgeschlagenen Ansatzes, bei dem im Schritt des Verbindens ein Träger mit dem Zwischensubstrat verbunden wird, der zumindest teilweise Silizium aufweist, insbesondere der aus Silizium gefertigt ist. Eine solche Ausführungsform des hier vorgestellten Ansatzes bietet den Vorteil der Verwendung eines breit und kostengünstig verfügbaren Siliziumwafers als Träger entsprechend der hier verwendeten Nomenklatur.

Gemäß einer weiteren Ausführungsform des hier vorgeschlagenen Ansatzes kann im Schritt des Verbindens ein Membranwafer und/oder ein Zwischensubstrat verwendet werden, der oder die zumindest teilweise Silizium-Nitrid aufweist, insbesondere der oder die aus Silizium-Nitrid besteht.

Denkbar ist ferner Ausführungsform des hier vorgeschlagenen Ansatzes als Anordnung zur Herstellung eines optischen Elementes mit mikrooptischen Strukturen, bestehend aus einem Membranwafer als Trägerbasis der mikrooptischen Strukturen, einem Zwischensubstrat und einem Träger, die miteinander verbunden sind, und deren thermische Ausdehnungskoeffizienten so bemessen sind, dass der Ausdehnungskoeffizient des Trägers größer als der des Zwischensubstrats ist und das Zwischensubstrat einen Ausdehnungskoeffizienten besitzt, welcher größer oder gleich dem Ausdehnungskoeffizienten des Membranwafers ist.

Zugleich wird mit dem hier vorgestellten Ansatzes eine Ausführungsform als optisches Element mit mikrooptischen Strukturen vorgestellt, die einen Membranwafer als Trägerbasis der Membran, welche ihrerseits wiederum der Träger der mikrooptischen Strukturen ist, ein mit dem Membranwafer verbundenes Zwischensubstrat und einen mit dem Zwischensubstrat verbundenen Träger aufweist, wobei die thermischen Ausdehnungskoeffizienten des Membranwafers, des Zwischensubstrats und des Trägers so bemessen sind, dass ein Ausdehnungskoeffizient des Trägers größer als ein Ausdehnungskoeffizient des Zwischensubstrats ist und der Ausdehnungskoeffizient des Zwischensubstrats größer oder gleich einem Ausdehnungskoeffizienten des Membranwafers ist.

Vorteilhafte Ausführungsbeispiele der vorliegenden Erfindung werden anhand der nachfolgenden Zeichnungen näher beschrieben. Es zeigen:
- Fig. 1: eine Darstellung eines Prinzips der Entstehung von Zug und Druckspannungen im Verlauf des Aushärtens des Klebers bei höheren Temperaturen;
- Fig. 2: eine Darstellung, wie die in Fig. 1 gezeigten Spannungen zu einer Verbiegung des Verbundsystems aus Träger und Membranwafer und damit zu einer Verschlechterung der Ebenheit der Membranen führen;
- Fig. 3: Darstellungen einzelner Schritte der Herstellung eines Ausführungsbeispiels der hier vorgestellten Membrananordnung;
- Fig. 4: eine Darstellung einer möglichen Anordnung bzw. Membran, die gemäß einem hier vorgestellten Ansatz hergestellt wurde; und
- Fig. 5: ein Ablaufdiagramm eines Ausführungsbeispiels der vorliegenden Erfindung als Verfahren.

In der nachfolgenden Beschreibung werden gleiche oder ähnliche bzw. ähnlich wirkende Elemente gleiche oder ähnliche Bezugszeichen bezeichnet, wobei eine wiederholte Beschreibung dieser Elemente aus der Übersichtlichkeit verzichtet wird.

Die (Träger-)Membranen werden oft aus Si3N4 hergestellt, welches als dünner Film auf einem Si-Wafer aufgebracht wird, wonach anschließend in einem trocken- oder nasschemischen Verfahren das Silizium des Wafers bzw. Trägers selbst entfernt wird, sodass nur die dünne (-100 nm dicke) Membran stehen bleibt, welche an ihrem Rand vom Wafer gehalten wird. Durch eine geeignete Prozess-Führung bei der Beschichtung des Wafers kann eine hohe Ebenheit der auf diese Art erzeugten frei stehenden Membran gewährleistet werden, vorausgesetzt der die Membran tragende Wafer ist eben. Diese Art der Herstellung bedingt die Nutzung von dünnen Substraten/Wafern (Dicke typischerweise ≤1 mm), da zum einen die Ätzzeiten für dickere Substrate sehr stark ansteigen und zum Anderen dickere Substrate häufig eine Einengung der geometrisch möglichen diffraktiven Strukturen bedeuten.

Diese Wafer mit optisch aktiven Membranen (kurz Membranwafer) sollten, um bestimmte optische Funktionen erfüllen zu können, eine hohe Ebenheit aufweisen. Da sie aufgrund ihrer geringen Dicke eine geringe mechanische Stabilität vor allem gegen Verbiegen aufweisen, sollten sie, um sie in optische Systeme integrieren zu können, häufig auf stabile Halter aufgebracht werden. Dieses Aufbringen kann auf verschiedene Arten geschehen z. B. mittels Kleber oder auch sogenanntes "Bonden".

Bei letztgenanntem Verfahren wird z. B. zwischen den Membranwafer und den Träger eine reaktive Zwischenschicht eingebracht, welche anschließend mittels einer exothermen Reaktion eine dauerhafte Verbindung ermöglicht. In der DE 10 2009 006 822 A1 ist zusätzlich beschrieben, wie diese reaktive Zwischenschicht noch strukturiert werden kann, sodass die Verbindung räumlich begrenzt durchgeführt werden kann. Ein Nachteil dieses Verfahrens ist es, dass die reaktive Zwischenschicht bzw. die Zwischenschicht nach dem reaktiven Bonden eine konstante Dicke aufweist. Das heißt aber auch, dass sich die Dickenvariation des Membranwafers (Total Thickness Variation - TTV) welche fast immer größer als 1µm ist, unmittelbar in eine Unebenheit der Membranwaferoberfläche überträgt. Gleiches gilt auch für eine bereits vorhandene Unebenheit der Substratoberfläche.

Um die oben genannten Nachteile des Bondens zu umgehen, kann der Membranwafer auf den Träger (oder allgemeiner ein Substrat) geklebt werden, wobei die Kleberschicht dabei die TTV des Membranwafers und die Unebenheit des Substrates/Trägers ausgleichen kann. Um die gewünschte Ebenheit des Membran-Wafers zu erreichen, wird dieser meist auf seiner Oberseite an eine sehr ebene Fläche angesaugt (ein sogenannter Vakuum-Chuck) und danach mit dem Substrat verklebt.

Um die Endfestigkeit des Klebers zu erreichen, ist meist ein sogenanntes "Härten" des Klebers notwendig, welches entweder durch Bestrahlung mit ultraviolettem Licht (UV) oder durch Erwärmen auf Temperaturen, welche deutlich höher sind als Zimmer- (und damit die Verarbeitungs-) Temperatur. UV-härtende Kleber können dabei nur eingesetzt werden, wenn mindestens entweder der zu verklebende Membranwafer oder das Substrat/die Trägerstruktur für UV transparent ist. Für die meisten Membranwafer trifft dies nicht zu, da sie, wie oben beschrieben, aus Silizium bestehen. Die Substrate/Träger sind oft aus keramischen Materialien und damit ebenfalls UV-intransparent. In diesen Fällen kommen oft Kleber zum Einsatz, welche bei höheren Temperaturen aushärten.

Während des Härtens passiert Folgendes: Der Membranwafer und das Substrat dehnen sich entsprechend ihrer spezifischen thermischen Ausdehnungskoeffizienten (Coefficient of Thermal Expansion - kurz: CTE) aus. Bei unterschiedlichen Materialen (und damit unterschiedlichen entsprechenden Ausdehnungskoeffizienten CTE's) kommt es dabei zu einem Stress oder Druck im Kleber, welcher dieser aber, da er noch nicht vollständig ausgehärtet ist, d. h. seine Endfestigkeit erreicht hat, zum Teil ausgleichen kann. In diesem Zustand härtet der Kleber aus, d. h., er ist sehr viel weniger in der Lage, den Stress aufgrund der unterschiedlichen negativen Ausdehnung in folge der Abkühlung auszugleichen. Daher resultiert eine Verbiegung des Systems Membranwafer/Substrat und damit einer Verschlechterung der Ebenheit der Membranwaferoberfläche (der Effekt ist ähnlich dem "Bi-Metall-Effekt). Dies wiederum führt dazu, dass die mikrooptischen (diffraktiven) Strukturen nicht mehr mit der notwendigen Genauigkeit oder Ausrichtung/Parallelität zueinander im optischen System gehalten werden können.

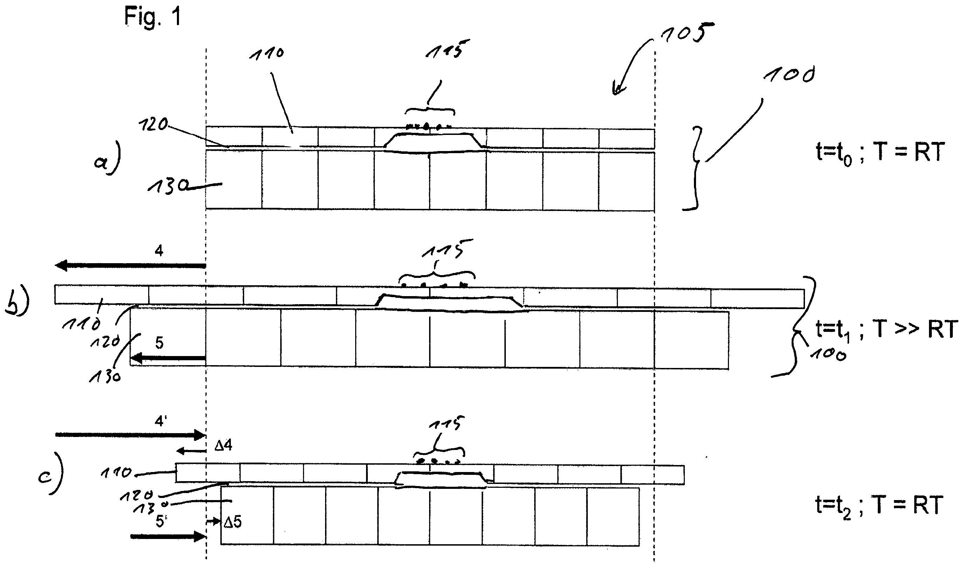

Fig. 1 zeigt in den Teilfiguren 1a bis 1c Darstellungen eines Schichtenverbunds 100 zur Herstellung eines optischen Elementes 105 bei unterschiedlichen Temperaturen während des Schritts des Verbindens des Membranwafers 110 unter Verwendung eines Klebematerials 120 und des Trägers 130, wobei noch kein Zwischensubstrat verwendet wird. Der Membranwafer 110 umfasst dabei diffraktive oder mikrooptische Strukturen 115, die in einem nachfolgend fertig ausprozessierten optischen Element 105 eine vorbestimmte Beugung oder Brechung von auf diese Strukturen 115 einfallendem EUV- bzw. UV-Licht bewirken, um eine gewünschte Feldverteilung an einem gewünschten Ort im optischen System zu erhalten. Die Membran befindet sich meist nur unmittelbar unter den mikrooptischen Strukturen 115 und ist viel kleiner als der Membranwafer 110 bzw. die gesamte Baugruppe bzw. der Schichtenverbund 100. Der thermische Ausdehnungskoeffizient CTE₁ des Membranwafers 110 und der thermische Ausdehnungskoeffizient CTE₂ des Trägers 130 sind so bemessen, dass der Ausdehnungskoeffizient CTE₂ des Trägers 130 größer oder gleich dem Ausdehnungskoeffizienten CTE₁ des Membranwafers 110 ist. Die Teile des optischen Elementes 105, also der Membranwafer 110 und der Träger 130 sind mit einem Kleber 120 bzw. Klebematerial verbunden, welcher bei Temperaturen aushärtet, welche deutlich höher als Raumtemperatur sind. Unter deutlich höheren Temperaturen werden hierbei insbesondere Temperaturen von über 50 Grad Celsius, insbesondere über 80 Grad Celsius, verstanden.

Wird nun in einem Schritt des Aushärtens zu einem Startzeitpunkt t=t0, bei dem der Schichtverbund 100 Raumtemperatur RT aufweist, (so, wie es in der Fig. 1a darstellt ist) auf eine Temperatur T aufgeheizt, die deutlich größer als Raumtemperatur ist, dehnen sich zu einem dem Startzeitpunkt t0 nachfolgenden Zeitpunkt t1 der Membranwafer 110 um den Längenbetrag 4 aus, wogegen sich der Träger lediglich um einen Längenbetrag 5 ausdehnt. Die Abmessungen der einzelnen Komponenten des Schichtverbunds 100 zum Zeitpunkt t1 sind dabei in der Fig. 1b dargestellt. In dieser Situation kann der Kleber 120 aushärten und den Membranwafer 110 und den Träger 130 in den entsprechenden Positionen gegeneinander fixieren.

Kühlt nun der Schichtverbund 100 wieder ab, beispielsweise auf Raumtemperatur RT zum Zeitpunkt t2, kontrahieren die einzelnen Komponenten des Halbzeugs 105, also der Membranwafer 110, und der Träger 130 unterschiedlich stark, so wie es in der Fig. 1c dargestellt ist. Die einzelnen Komponenten des Schichtverbunds 100, also der Membranwafer 110, und der Träger 130, sollten sich dabei um den jeweils gleichen Betrag 4' bzw. 5' wie beim Aufheizen auf die erhöhte Temperatur zum Zeitpunkt t1 zurückkontrahieren, was jedoch durch die Fixierung nach Aushärtung des Klebers nicht mehr möglich ist. Gegenüber der Ausdehnung der Komponenten Membranwafer 110 und Träger 130 ist der Membranwafer 110 daher nach der Abkühlung um den Betrag Δ4 verlängert, wogegen der Träger 130 um den Betrag Δ5 verkürzt wurde. Hierdurch ergibt sich eine Zugspannung des Membranwafers 110 durch die Fixierung auf dem Träger 130, die dazu führt, dass der Membranwafer 110, mit den darauf aufgebrachten mikrooptischen Strukturen 115 verbogen wird.

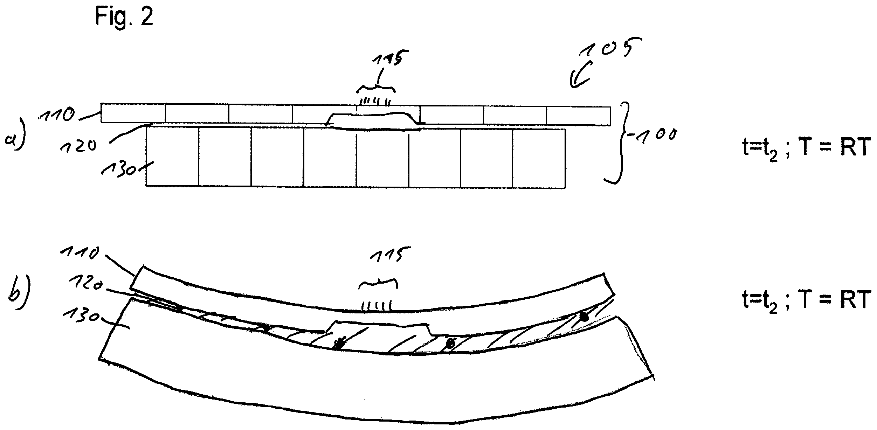

Fig. 2 zeigt in zwei Teilfiguren 2a und 2b eine Darstellung einer Durchbiegung der Anordnung der Komponenten 110 und 130 eines optischen Elementes 105, bei der der (Membran-) Wafer 110 mit dem Substrat bzw. Träger 130 verklebt wurde. Hierbei wird erkennbar, dass bei einer Verklebung unter Verwendung der unterschiedlichen thermischen Ausdehnungskoeffizienten gemäß der Darstellung aus Fig. 2a zu einem Schichtverbund 100 entsprechend der Darstellung aus der Fig. 1c führt. Wird jedoch lediglich eine konventionelle Klebung eingefügt, kommt es nach der Klebung zum Zeitpunkt t2 zu einem durchgebogenen Schichtverbund 100, wie es in der Fig. 2b dargestellt ist und wobei die mikrooptischen Strukturen 115 durch die unkontrollierte Durchbiegung des Schichtverbunds 100 nicht mehr optimal verwendbar sind. In Fig. 2 wird somit gezeigt, dass der Zugstress des Membranwafers 110 bzw. der Druckstress des Substrates 130 in einer Verbiegung der gesamten Anordnung und damit in einer Verschlechterung der Oberflächenebenheit der Membran des Membranwafers 110 resultiert. Diese Verbiegung als Resultat der wie in Fig. 1 entstehenden Zug- und Druckspannungen ist in Fig. 2 gezeigt. Auls der Verbiegung des Schichtverbunds folgt unmittelbar die Verschlechterung der Ebenheit des Membranwafers.

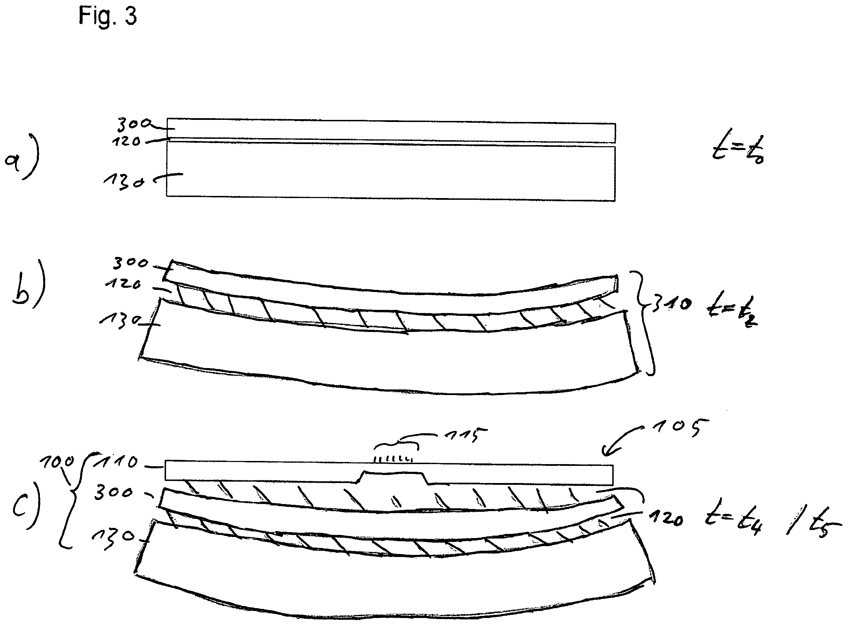

Fig. 3 zeigt in Teilfiguren 3a bis 3c Darstellungen einzelner Schritte der Herstellung eines Ausführungsbeispiels des hier vorgestellten optischen Elementes 105. Hierbei wird zunächst entsprechend der Darstellung aus Fig. 3a zu einem Zeitpunkt t0 auf den eben hergestellten Träger 130 als erstes Substrat das Zwischensubstrat 300 mit dem Klebematerial 120 eben aufgeklebt und dann durch Temperaturerhöhung temperiert, sodass zum Zeitpunkt t2 ein erstes Teil 310 entsprechend der Darstellung aus Fig. 3b resultiert, bei dem die Klebeverbindung ausgehärtet ist. Als Zwischensubstrat 300 kann beispielsweise ein Material verwendet werden, das einen Ausdehnungskoeffizienten CTE_{Z} aufweist, der kleiner als der Ausdehnungskoeffizient des Trägers ist und aber auch größer oder gleich einem Ausdehnungskoeffizienten des Membranwafers ist. Der in Fig. 3b gezeigte Zwischenzustand entspricht dem in Fig. 2b gezeigten Endzustand. Nun kann gemäß einem vorteilhaften Ausführungsbeispiel das Zwischensubstrat 300 eingeebnet werden und der Membranwafer 110 als zweites Substrat auf das erste Teil 310 (beispielsweise unter erneuter Verwendung des zuvor verwendeten Klebematerials 120) aufgeklebt werden, wonach das Klebematerial erneut ausgehärtet wird. Eine weitere Möglichkeit ist, dass die durchgebogene/unebene Oberfläche des Zwischensubstrats 300 belassen wird und der Kleber 120 den unterschiedlich dicken/breiten Klebespalt ausfüllt. Auf diese weise kann nun erreicht werden, dass der auf dem Zwischensubstrat aufgeklebte Membranwafer 110 eben gehalten wird und sich dank des Einfügens einer Zwischensubstrat 300 nicht mehr verbiegt, auch wenn ein heißhärtender Kleber benutzt wird.

Der hier vorgeschlagene Ansatz beschreibt somit eine Anordnung, welche aus dem Membranwafer 110 (als Trägerbasis der mikrooptischen Strukturen 115), einem Zwischensubstrat 300 und einem Träger 130 besteht, wobei deren thermische Ausdehnungskoeffizienten (CTEs) so bemessen sind, dass der Ausdehnungskoeffizient CTE2 des Trägers 130 größer als der des Zwischensubstrats 300 ist und das Zwischensubstrat 300 einen Ausdehnungskoeffizienten CTEZ besitzt, welcher größer oder gleich dem Ausdehnungskoeffizienten CTE1 des Membranwafers 110 (aber kleiner als CTE1 des Trägers 130) ist. Alle drei Teile 110, 300 und 130 sind mit Kleber 120 verbunden, welcher bei Temperaturen aushärtet, welche deutlich höher als Raumtemperatur sind. Unter deutlich höheren Temperaturen werden hierbei insbesondere Temperaturen von über 50 Grad Celsius, insbesondere über 80 Grad Celsius, verstanden.

Durch die beschriebene Wahl der thermischen Ausdehnungskoeffizienten wird im Membranwafer 110 eine Zugspannung erzeugt, was zu einer Verbesserung der Ebenheit der nachfolgend hergestellten Membranen 105 und damit der mikrooptischen Strukturen 115 führt.

Auch bei gleichem CTE ergibt sich eine bessere Ebenheit, da das "CTE-Mismatch" schon auf der Oberfläche des Zwischensubstrats zu einer Verbiegung führt, und danach bei Aushärten der zweiten Klebeverbindung den Membranwafer 110 aufgrund der Übereinstimmung der CTE's nicht noch zusätzlich verbiegt.

Insofern wird eine Anordnung beschrieben, die insbesondere dadurch gekennzeichnet ist, dass auf ein erstes Substrat mit einem materialspezifischen ersten thermischen Ausdehnungskoeffizienten CTE1 ein Zwischensubstrat mit einem materialspezifischen thermischen Zwischenausdehnungskoeffizienten CTEz aufgeklebt ist und auf diesem ein zweites Substrat mit einem materialspezifischen zweiten thermischen Ausdehnungskoeffizienten CTE2 aufgeklebt ist, wobei der erste thermischen Ausdehnungskoeffizient CTE1 kleiner als der thermischen Zwischenausdehnungskoeffizient und der der thermischen Zwischenausdehnungskoeffizient kleiner oder gleich dem zweiten thermischen Ausdehnungskoeffizient ist, dass also CTE1<CTEz≤CTE2 gilt. Ferner wird offenbart, dass die vorstehend genannten Komponenten besonders vorteilhaft mit einem heiß härtenden Kleber verbunden werden können und/oder dass in einem günstigen Ausführungsbeispiel der thermische Zwischenausdehnungskoeffizient gleich dem zweiten thermischen Ausdehnungskoeffizienten ist, dass also gilt: CTEz=CTE2. Zusätzlich oder alternativ sollte die Membran sehr eben oder planar sein und/oder der Membranwafer 110 Silizium umfassen oder daraus bestehen.

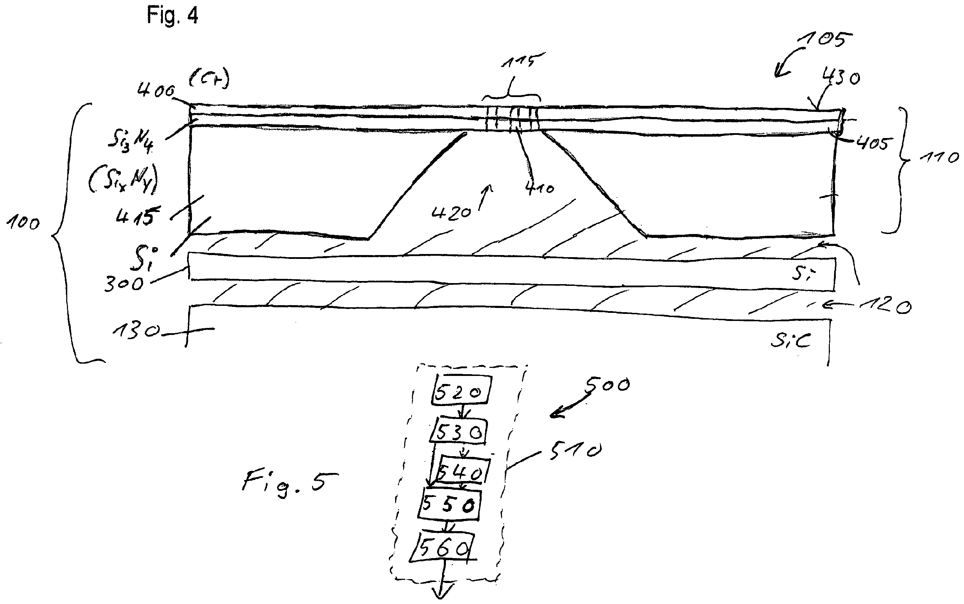

Fig. 4 zeigt eine Darstellung eines optischen Elementes 105, der gemäß einem hier vorgestellten Ansatz hergestellt wurde. Hierbei ist der Membranwafer 110 zumindest in einer Teillage 405 aus Si3N4 gefertigt und weist eine Absorberlage 400 auf, in die die diffraktiven oder mikrooptischen Strukturen 115, welche beispielsweise durch Öffnungen in der Absorberschicht gebildet werden, eingebettet sind. Denkbar ist jedoch auch, dass statt dem Si₃N₄ ein beliebiges anderes Silizium-Nitrit, also SiₓN_{y} verwendet werden kann. Die Absorberlage 400 kann beispielsweise aus Chrom Cr bestehen oder dieses Element enthalten. Die mikrooptischen Strukturen 115 können als Durchätzungen 410 durch die Absorberlage und/oder die Si3N4-Lage auf einem Silizium-Träger 415 ausgebildet sein. Im Bereich der mikrooptischen Strukturen 115 ist der Membranwafer 110, beispielsweise durch einen aus der Halbleitertechnik wohlbekannten Schritt des Nass- oder Trockenätzens derart strukturiert, dass er in diesem Bereich 420 eine Öffnung oder Aussparung aufweist, durch die von einer der Si₃N₄-Schicht gegenüberliegenden Seite des Träges 130 her betrachtet, die mikrooptischen Strukturen 115 freiliegen. Das Zwischensubstrat 300 ist in dem Ausführungsbeispiel des optischen Elementes 105 gemäß der Fig. 4 unterhalb des Membranwafers 110 angeordnet und über ein Klebematerial 120 an dem Membranwafer 110 befestigt. Das Zwischensubtrat 300 ist beispielsweise dünner als der Membranwafer 110 und kann beispielsweise ebenfalls aus einem Silizium-Material bestehen und weist dann den gleichen Ausdehnungskoeffizienten auf, wie der Membranwafer bzw. der Silizium-Träger 415 des Membranwafers. Weiterhin ist der Membranwafer 110 und das an dem Membranwafer 110 befestigte Zwischensubstrat 300 auf dem Träger 130 aufgebracht bzw. mit dem Klebematerial 120 aufgeklebt, der aus einem Silizium-Carbid-Träger bestehen kann oder zumindest teilweise Silizium-Carbid oder SiSiC aufweist. Hierdurch kann ein optisches Element 105 mit einem Rand aus dem Material des Träges 130 hergestellt werden, deren Oberfläche 430 eine sehr geringe Durchbiegung von beispielsweise weniger als 1 µm im Bereich der mikrooptischen Strukturen 115 aufweist. Anders ausgedrückt kann bei einer solchen Membran 105 eine sehr große Ebenheit oder planare Oberfläche 430 sichergestellt werden.

Fig. 5 zeigt ein Ablaufdiagramm eines Ausführungsbeispiels der vorliegenden Erfindung als Verfahren 500 zur Herstellung eines optischen Elementes 105 mit mikrooptischen Strukturen 115. Das Verfahren 500 umfasst einen Schritt 510 des Verbindens, in dem der Membranwafer 110 als Träger der mikrooptischen Strukturen 115 über ein Zwischensubstrat 300 mit einem Träger 130 verbunden wird, wobei die thermischen Ausdehnungskoeffizienten des Membranwafers 110, des Zwischensubstrats 300 und des Trägers 130 so bemessen sind, dass ein Ausdehnungskoeffizient des Trägers 130 größer als ein Ausdehnungskoeffizient des Zwischensubstrats 300 ist und der Ausdehnungskoeffizient des Zwischensubstrats 300 größer oder gleich einem Ausdehnungskoeffizienten des Membranwafers 110 ist. Der Schritt des Verbindens 510 umfast dabei gemäß einem besonders günstigen Ausführungsbeispiel mehrere Teilschritte. Beispielsweise kann in einem ersten Teilschritt 520 ein Aufkleben des Zwischensubstrats 300 mit einem Klebematerial 120 auf den Träger 130 erfolgen. In einem nachfolgenden Schritt 530 des Aushärtens kann das Klebematerial 120 ausgehärtet werden, beispielsweise unter Verwendung eines Temperierens oder Erhitzens des Trägers 130, des Zwischensubstrats 300 und des die beiden Komponenten verbindenden Klebematerials 120. Hiernach kann wiederum in einem weiteren optionalen Teilschritt 540 des Einebnens ein Polieren des Zwischensubstrats 300 erfolgen, um eine ebene Oberfläche des Verbunds 310 aus Träger 130 und Zwischensubstrat 300 zu erhalten. Hieran anschließend kann in einem folgenden Teilschritt 550 ein Aufkleben des Membranwafers 110 auf den Verbund 310 aus Zwischensubstrat 300 und Träger 130 erfolgen, beispielsweise wieder unter Verwendung des Klebematerials 120 aus dem vorangegangenen Teilschritt 520 des Aufklebens. Schlussendlich kann in einem nachfolgenden Teilschritt 560 ein Aushärten des Klebematerials 120 zwischen dem Membranwafer 110 und dem Verbund 310 aus Zwischensubstrat 300 und Träger 130 erfolgen. Auf diese Weise kann ein optisches Element 105 hergestellt werden, das eine sehr ebene oder planare Oberfläche des Membranwafers 110 bzw. der Membran des Membranwafers 110 aufweist.

## Patentansprüche

1. Optisches Element(105) mit mikrooptischen Strukturen (115), das einen Membranwafer (110) als Trägerbasis der mikrooptischen Strukturen (115), ein mit dem Membranwafer (110) verbundenes Zwischensubstrat (300) und einen mit dem Zwischensubstrat (300) verbundenen Träger (130) aufweist, **dadurch gekennzeichnet, dass** die thermischen Ausdehnungskoeffizienten des Membranwafers (110), des Zwischensubstrats (300) und des Trägers (130) so bemessen sind, dass ein Ausdehnungskoeffizient des Trägers (130) größer als ein Ausdehnungskoeffizient des Zwischensubstrats (300) ist und der Ausdehnungskoeffizient des Zwischensubstrats (300) größer oder gleich einem Ausdehnungskoeffizienten des Membranwafers (110) ist.

2. Verfahren (500) zur Herstellung eines optischen Elementes (105) mit mikrooptischen Strukturen (115), wobei das Verfahren (500) einen Schritt (510) des Verbindens aufweist, in dem ein Membranwafer (110) als Trägerbasis der mikrooptischen Strukturen (115) über ein Zwischensubstrat (300) mit einem Träger (130) verbunden wird, **dadurch gekennzeichnet, dass** die thermischen Ausdehnungskoeffizienten des Membranwafers (110), des Zwischensubstrats (300) und des Trägers (130) so bemessen sind, dass ein Ausdehnungskoeffizient des Trägers (130) größer als ein Ausdehnungskoeffizient des Zwischensubstrats (300) ist und der Ausdehnungskoeffizient des Zwischensubstrats (300) größer oder gleich einem Ausdehnungskoeffizienten des Membranwafers (110) ist.

3. Verfahren (500) zur Herstellung eines optischen Elementes (105) mit mikrooptischen Strukturen (115) nach Anspruch 2 **dadurch gekennzeichnet, dass** im Schritt (510) des Verbindens Membranwafer (110), Zwischensubstrat (300) und Träger (130) mit einem Klebermaterial (120) verbunden werden, welcher bei einer Temperatur (T) aushärtet, welche höher als die Raumtemperatur (RT) ist, insbesondere der bei einer Temperatur (T) von zumindest 50 °C aushärtet.

4. Verfahren (500) gemäß Anspruch 3, **dadurch gekennzeichnet, dass** der Schritt (510) des Verbindens ferner einen Teilschritt (520) des Aufklebens, einen Teilschritt (530) des Aushärtens, einen Teilschritt (540) des Einebnens, einen Teilschritt (550) des weiteren Aufklebens und ein Teilschritt (560) des weiteren Aushärtens aufweist , wobei im Schritt (520) des Aufklebens das Zwischensubstrat (300) auf den Träger (130) aufgeklebt wird, im Teilschritt (530) des Aushärtens das Klebermaterial (120) ausgehärtet wird, im Teilschritt (540) des Einebnens eine Oberfläche des Zwischensubstrats eingeebnet, insbesondere poliert wird, im Teilschritt (550) des weiteren Aufklebens der Membranwafer (110) auf einen Verbund (310) aus Träger (130) und Zwischensubstrat (300) aufgeklebt wird, und im Teilschritt (560) des Aushärtens das Klebematerial (120) zwischen dem Membranwafer (110) und dem Verbund (310) ausgehärtet wird.

5. Verfahren (500) gemäß einem der Ansprüche 2 bis 4, **dadurch gekennzeichnet, dass** im Schritt (510) des Verbindens ein Zwischensubstrat (300) und ein Membranwafer (110) verbunden werden, wobei der Ausdehnungskoeffizient des Zwischensubstrats (300) gleich einem Ausdehnungskoeffizienten des Membranwafers (110) ist.

6. Verfahren (500) gemäß einem der Ansprüche 2 bis 5, **dadurch gekennzeichnet, dass** im Schritt (510) des Verbindens einer Oberfläche (430) des Membranwafers (110) erzeugt wird, die eine Durchbiegung von weniger als 1 µm aufweist.

7. Verfahren (500) gemäß einem der Ansprüche 2 bis 6, **dadurch gekennzeichnet, dass** im Schritt des Verbindens (510) ein Träger (130) mit dem Zwischensubstrat (300) verbunden wird, der zumindest teilweise SiC und/oder SiSiC aufweist, insbesondere der aus SiC oder SiSiC gefertigt ist.

8. Verfahren (500) gemäß einem der Ansprüche 2 bis 7, **dadurch gekennzeichnet, dass** im Schritt (510) des Verbindens ein Membranwafer (110) verwendet wird, der oder die zumindest teilweise Silizium-Nitrid aufweist, insbesondere der oder die aus Silizium-Nitrid besteht.

9. Anordnung zur Herstellung eines optischen Elementes (105) mit mikrooptischen Strukturen (115), bestehend aus einem Membranwafer (110) als Trägerbasis der mikrooptischen Strukturen (115), ein Zwischensubstrat (300) und einem Träger (130), die miteinander verbunden sind, **dadurch gekennzeichnet, dass** deren thermische Ausdehnungskoeffizienten so bemessen sind, dass der Ausdehnungskoeffizient des Trägers (130) größer als der des Zwischensubstrats (300) ist und das Zwischensubstrat (300) einen Ausdehnungskoeffizienten besitzt, welcher größer oder gleich dem Ausdehnungskoeffizienten des Membranwafers (110) ist.

10. Anordnung zur Herstellung eines optischen Elementes (105) mit mikrooptischen Strukturen (115) nach Anspruch 9, **dadurch gekennzeichnet, dass** der Kleber (120), welcher den Membranwafer (110), Zwischensubstrat (300) und Träger (130) verbindet, ein Kleber (120) ist, welcher bei Temperaturen (T) aushärtet, welche deutlich höher als die Raumtemperatur (RT) ist.

## Claims

1. Optical element (105) comprising micro-optical structures (115), which comprises a membrane wafer (110) as carrier basis of the micro-optical structures (115), an intermediate substrate (300) connected to the membrane wafer (110), and a carrier (130), connected to the intermediate substrate (300), **characterized in that** the coefficients of thermal expansion of the membrane wafer (110), of the intermediate substrate (300) and of the carrier (130) are dimensioned such that a coefficient of expansion of the carrier (130) is greater than a coefficient of expansion of the intermediate substrate (300) and the coefficient of expansion of the intermediate substrate (300) is greater than or equal to a coefficient of expansion of the membrane wafer (110).

2. Method (500) for producing an optical element (105) comprising micro-optical structures (115), wherein the method (500) comprises a step (510) of connecting, in which a membrane wafer (110) as carrier basis of the micro-optical structures (115) is connected to a carrier (130) via an intermediate substrate (300), **characterized in that** the coefficients of thermal expansion of the membrane wafer (110), of the intermediate substrate (300) and of the carrier (130) are dimensioned such that a coefficient of expansion of the carrier (130) is greater than a coefficient of expansion of the intermediate substrate (300) and the coefficient of expansion of the intermediate substrate (300) is greater than or equal to a coefficient of expansion of the membrane wafer (110).

3. Method (500) for producing an optical element (105) comprising micro-optical structures (115) according to Claim 2, **characterized in that** in step (510) of connecting, the membrane wafer (110), intermediate substrate (300) and carrier (130) are connected using an adhesive material (120) which cures at a temperature (T) which is higher than room temperature (RT), in particular which cures at a temperature (T) of at least 50°C.

4. Method (500) according to Claim 3, **characterized in that** the step (510) of connecting furthermore comprises a substep (520) of adhesive bonding, a substep (530) of curing, a substep (540) of levelling, a substep (550) of further adhesive bonding and a substep (560) of further curing, wherein in step (520) of adhesive bonding, the intermediate substrate (300) is adhesively bonded onto the carrier (130), in substep (530) of curing, the adhesive material (120) is cured, in substep (540) of levelling, a surface of the intermediate substrate is levelled, in particular polished, in substep (550) of further adhesive bonding, the membrane wafer (110) is adhesively bonded onto a composite (310) comprising the carrier (130) and intermediate substrate (300), and in substep (560) of curing, the adhesive material (120) between the membrane wafer (110) and the composite (310) is cured.

5. Method (500) according to one of Claims 2 to 4, **characterized in that** in step (510) of connecting, an intermediate substrate (300) and a membrane wafer (110) are connected, wherein the coefficient of expansion of the intermediate substrate (300) is equal to a coefficient of expansion of the membrane wafer (110).

6. Method (500) according to one of Claims 2 to 5, **characterized in that** in step (510) of connecting, a surface (430) of the membrane wafer (110) is produced which has a deflection of less than 1 µm.

7. Method (500) according to one of Claims 2 to 6, **characterized in that** in step (510) of connecting, a carrier (130) is connected to the intermediate substrate (300), said carrier including at least partly SiC and/or SiSiC, in particular said carrier being produced from SiC or SiSiC.

8. Method (500) according to one of Claims 2 to 7, **characterized in that** in step (510) of connecting, a membrane wafer (110) is used which at least partly includes silicon nitride, in particular which consists of silicon nitride.

9. Arrangement for producing an optical element (105) comprising micro-optical structures (115), consisting of a membrane wafer (110) as carrier basis of the micro-optical structures (115), an intermediate substrate (300) and a carrier (130), which are connected to one another, **characterized in that** the coefficients of thermal expansion thereof are dimensioned such that the coefficient of expansion of the carrier (130) is greater than that of the intermediate substrate (300) and the intermediate substrate (300) has a coefficient of expansion which is greater than or equal to the coefficient of expansion of the membrane wafer (110).

10. Arrangement for producing an optical element (105) comprising micro-optical structures (115) according to Claim 9, **characterized in that** the adhesive (120) which connects the membrane wafer (110), intermediate substrate (300) and carrier (130) is an adhesive (120) which cures at temperatures (T) which are significantly higher than room temperature (RT).

## Revendications

1. Élément optique (105) qui est pourvu de structures micro-optiques (115) et qui comporte une plaquette membranaire (110) servant de base de support aux structures micro-optiques (115), un substrat intermédiaire (300) relié à la plaquette membranaire (110) et un support (130) relié au substrat intermédiaire (300), **caractérisé en ce que** les coefficients de dilatation thermique de la plaquette membranaire (110), du substrat intermédiaire (300) et du support (130) sont dimensionnés de telle sorte qu'un coefficient de dilatation du support (130) soit supérieur à un coefficient de dilatation du substrat intermédiaire (300) et le coefficient de dilatation du substrat intermédiaire (300) soit supérieur ou égal à un coefficient de dilatation de la plaquette membranaire (110).

2. Procédé (500) de fabrication d'un élément optique (105) pourvu de structures micro-optiques (115), le procédé (500) comportant une étape (510) de liaison dans laquelle une plaquette membranaire (110) servant de base de support aux structures micro-optiques (115) est reliée à un support (130) par le biais d'un substrat intermédiaire (300), **caractérisé en ce que** les coefficients de dilatation thermique de la plaquette membranaire (110), du substrat intermédiaire (300) et du support (130) sont dimensionnés de telle sorte qu'un coefficient de dilatation du support (130) soit supérieur à un coefficient de dilatation du substrat intermédiaire (300) et le coefficient de dilatation du substrat intermédiaire (300) soit supérieur ou égal à un coefficient de dilatation de la plaquette membranaire (110) .

3. Procédé (500) de fabrication d'un élément optique (105) pourvu de structures micro-optiques (115) selon la revendication 2, **caractérisé en ce que**, à l'étape (510) de liaison, la plaquette membranaire (110), le substrat intermédiaire (300) et le support (130) sont reliés à une matière adhésive (120) qui durcit à une température (T) supérieure à la température ambiante (RT), notamment qui durcit à une température (T) d'au moins 50 °C.

4. Procédé (500) selon la revendication 3, **caractérisé en ce que** l'étape (510) de liaison comprend en outre une sous-étape (520) de collage, une sous-étape (530) de durcissement, une sous-étape (540) d'aplanissement, une sous-étape (550) de collage supplémentaire et une sous-étape (560) de durcissement supplémentaire, le substrat intermédiaire (300) étant collé au support (130) à l'étape (520) de collage, la matière adhésive (120) étant durcie à la sous-étape (530) de durcissement, une surface du substrat intermédiaire étant aplanie, notamment polie, à la sous-étape (540) d'aplanissement, la plaquette membranaire (110) étant collée sur un composite (310) formé du support (130) et du substrat intermédiaire (300) à la sous-étape (550) de collage supplémentaire, et la matière adhésive (120) étant durcie entre la plaquette membranaire (110) et le composite (310) à la sous-étape (560) de durcissement.

5. Procédé (500) selon l'une des revendications 2 à 4, **caractérisé en ce qu'**un substrat intermédiaire (300) et une plaquette membranaire (110) sont reliés à l'étape (510) de liaison, le coefficient de dilatation du substrat intermédiaire (300) étant égal à un coefficient de dilatation de la plaquette membranaire (110).

6. Procédé (500) selon l'une des revendications 2 à 5, **caractérisé en ce qu'**une surface (430) de la plaquette membranaire (110), qui présente une déflexion inférieure à 1 µm, est réalisée à l'étape (510) de raccordement.

7. Procédé (500) selon l'une des revendications 2 à 6, **caractérisé en ce que**, à l'étape de liaison (510), un support (130) est relié au substrat intermédiaire (300), lequel support comporte au moins en partie du SiC et/ou du SiSiC, en particulier est fabriqué à partir de SiC ou de SiSiC.

8. Procédé (500) selon l'une des revendications 2 à 7, **caractérisé en ce que**, à l'étape (510) de liaison, une plaquette membranaire (110) est utilisée qui est au moins en partie en nitrure de silicium, notamment qui comprend du nitrure de silicium.

9. Ensemble de fabrication d'un élément optique (105) qui est pourvu de structures micro-optiques (115) et qui comprend une plaquette membranaire (110) servant de base de support aux structures micro-optiques (115), un substrat intermédiaire (300) et un support (130) qui sont reliés entre eux, **caractérisé en ce que** leurs coefficients de dilatation thermique sont dimensionnés de telle sorte que le coefficient de dilatation du support (130) soit supérieur à celui du substrat intermédiaire (300) et le substrat intermédiaire (300) ait un coefficient de dilatation qui est supérieur ou égal au coefficient de dilatation de la plaquette membranaire (110).

10. Ensemble de fabrication d'un élément optique (105) pourvu de structures micro-optiques (115) selon la revendication 9, **caractérisé en ce que** l'adhésif (120) qui relie la plaquette membranaire (110), le substrat intermédiaire (300) et le support (130) est un adhésif (120) qui durcit à des températures (T) qui sont nettement supérieures à la température ambiante (RT).
